**Europäisches Patentamt**

**European Patent Office**

**Office européen des brevets**

(19)

(11) Veröffentlichungsnummer: **0 106 188**
**B1**

(12) **EUROPÄISCHE PATENTSCHRIFT**

(45) Veröffentlichungstag der Patentschrift:
07.01.87

(21) Anmeldenummer: **83109264.8**

(22) Anmeldetag: **19.09.83**

(51) Int. Cl.⁴: **H 03 F 3/45**

(54) **Integrierte Verstärkerschaltung.**

(30) Priorität: **23.09.82 DE 3235289**

(43) Veröffentlichungstag der Anmeldung:
**25.04.84 Patentblatt 84/17**

(45) Bekanntmachung des Hinweises auf die Patenterteilung:
**07.01.87 Patentblatt 87/2**

(84) Benannte Vertragsstaaten:
**AT DE FR GB IT**

(56) Entgegenhaltungen:
**DE - A - 2 613 652**

**NTZ NACHRICHTENTECHNISCHE ZEITSCHRIFT, Band
33, Nr. 9, September 1980, Berlin Seiten 602-607
ELECTRONIC COMPONENTS AND APPLICATIONS,
Band 3, Nr. 2, Februar 1981, Eindhoven Seiten 66-86**

(73) Patentinhaber: **Siemens Aktiengesellschaft Berlin und
München, Wittelsbacherplatz 2, D-8000 München 2 (DE)**

(72) Erfinder: **Lenz, Michael, Ing.grad., Fischbachauer
Strasse 3, D-8000 München 90 (DE)**

Anmerkung: Innerhalb von neun Monaten nach der Bekanntmachung des Hinweises auf die Erteilung des europäischen
Patents im Europäischen Patentblatt kann jedermann beim Europäischen Patentamt gegen das erteilte europäische Patent
Einspruch einlegen. Der Einspruch ist schriftlich einzureichen und zu begründen. Er gilt erst als eingelegt, wenn die
Einspruchsgebühr entrichtet worden ist (Art. 99(1) Europäisches Patentübereinkommen).

## Beschreibung

Die vorliegende Erfindung bezieht sich auf eine integrierte Verstärkerschaltung mit einem Operationsverstärker nach dem Oberbegriff des Patentanspruches 1.

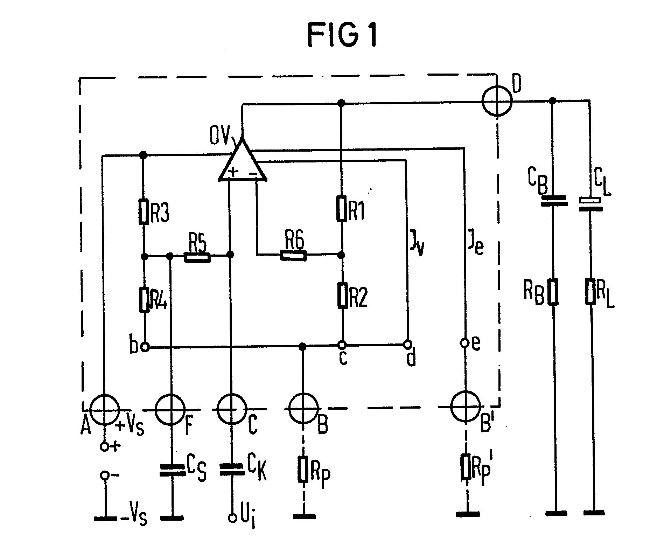

Solche Verstärkerschaltungen sind an sich – allerdings nur in nichtintegrierter Form – bekannt. Sie entsprechen im grossen und ganzen der aus der Figur 1 ersichtlichen Ausgestaltung. Dabei ist auch bei allen bekannten Schaltungen dieser Art der Signalausgang des Operationsverstärkers OV mit einer Signalausgangsklemme D verbunden, während der als Signaleingang für den Operationsverstärker OV vorgesehene nichtinvertierende Eingang unmittelbar mit der Eingangsklemme C verbunden ist. Ausserdem liegt der nichtinvertierende Eingang des Operationsverstärkers über einen Versorgungswiderstand R5 am Teilerpunkt eines aus zwei hintereinandergeschalteten Widerständen R3 und R4 bestehenden Spannungsteilers, dessen durch den Widerstand R3 gegebener Endpunkt an der Klemme A für das Versorgungspotential $+V_s$ und dessen durch den Widerstand R4 gegebener Endpunkt an der Klemme B für das Bezugspotential $-V_s$ liegt. Ein weiterer, aus den beiden hintereinandergeschalteten Widerständen R1 und R2 bestehender Spannungsteiler liegt mit dem durch den Widerstand R1 gegebenen Endpunkt am Signalausgang des Operationsverstärkers OV und mit seinem durch den Widerstand R2 gegebenen Endpunkt an der Klemme B für das Bezugspotential $-V_s$.

Diese Klemme B für das Bezugspotential $-V_s$ ist bei den bekannten integrierten Verstärkerschaltungen mit einem Operationsverstärker durchwegs nicht nur für die Beaufschlagung der beiden Signaleingänge des Operationsverstärkers, sondern auch für Bezugspotentialversorgung des eigentlichen Operationsverstärkers voll zuständig (d.h. also auch für die Punkte d und e, über die der Vorstufenstrom $I_v$ und der Endstufenstrom $I_E$ fliessen.

In Verbindung mit Figur 1 ist noch zu erwähnen, dass der Teilerpunkt des zweiten Spannungsteilers gemäss der obigen Definition, also des Spannungsteilers R3, R4, an eine Klemme F gelegt ist, welche zwecks Siebung über einen Kondensator $C_S$ an das Bezugspotential $-V_s$ angeschlossen ist. Weiter ist ein Koppelkondensator $C_K$ an der Signaleingangsklemme C vorgesehen, über den das zu verarbeitende Signal $U_i$ an die Schaltung weitergegeben und zum nichtinvertierenden Signaleingang des Operationsverstärkers OV geführt wird. Schliesslich ist die Signalausgangsklemme D für die Beaufschlagung eines Lastelements RL vorgesehen, die unter Vermittlung eines Koppelkondensators $C_L$ oder in sonst üblicher Weise erfolgen kann. Die beiden hintereinander geschalteten Schaltungsteile $C_L$ und $R_L$ werden durch die Serienschaltung eines weiteren Kondensators $C_B$ und eines Widerstandes $R_B$ überbrückt, wobei $R_B$ und $R_L$ am Bezugspotential $-V_s$ und $C_B$ sowie $C_L$ an der Ausgangsklemme D der Verstärkerschaltung liegen. Die Teile $R_B$ und $C_B$ bilden ein sog. Boucherot-Glied.

Nun wäre im Hinblick einer entsprechend den soeben gebrachten Ausführungen aufgebauten integrierten Verstärkerschaltung folgendes festzustellen: Man erkennt aus Figur 1, dass sich bei der Integration des Gegenkopplungsteilers R1, R2 der Gegenkopplungsfusspunkt (= R2) über den parasitären und durch den Anschlusspin B gegebenen Fusspunktwiderstand $R_P$ mit dem Polarisationsteiler R3, R4 mit dem Vorstufenstrom $J_v$ und mit dem Endstufenstrom $J_e$ verkoppelt wenn die Punkte d und e einfach verbunden werden. Diese Verkopplung führt jedoch zu einer störenden Erhöhung des Klirrfaktors der Verstärkerschaltung, die sich vor allem beim Einsatz einer solchen Schaltung als Ausgangsverstärker für Rundfunk- und Fernsehzwecke unangenehm bemerkbar macht.

Daraus folgt, dass die aus Figur 1 ersichtlichen Erdungspunkte b, c, d und e nicht mehr frei wählbar sind, da sie innerhalb der integrierten Schaltung liegen und damit festgelegt sind. Dies bedeutet, dass eine Abhilfe gegen die genannte Störung nicht so ohne weiteres möglich ist, sofern man mit den hierzu bekannten Mitteln arbeitet. Festzustellen ist weiter, dass der parasitäre Widerstand $R_P$ im wesentlichen durch den Widerstand des Anschlusspins und der Zuleitung zu dem das Bezugspotential $-V_s$ liefernden Pol der Versorgungsgleichspannungsquelle bedingt ist. Da demzufolge eine Abhilfe der genannten Störung durch die Erhöhung des Klirrfaktors bisher nicht zur Verfügung stand, musste von einer monolithischen Integration der eingangs definierten Verstärkerschaltung bisher abgesehen werden.

Es ist deshalb Aufgabe der Erfindung, einen Weg anzugeben, der der genannten Störung abhelfen kann.

Zur Lösung dieser Aufgabe ist eine Verstärkerschaltung der eingangs genannten Art erfindungsgemäss durch die Merkmale des kennzeichnenden Teils des Patentanspruchs 1 gekennzeichnet.

Aus der Zeitschrift «ntz», Vol. 33 (1980), Heft 9, Seiten 602 bis 607 ist es in anderem Zusammenhang, und zwar für mit Impedanzwandlern beschaltete Koppelpunkte bekannt, die Impedanzwandler mit getrennt abgelockten Vor- und Endstufenleitungen zu versehen. Dies geschieht zur Vermeidung von Nebensprechkopplungen.

Ausgestaltungen des Erfindungsgedankens sind in Unteransprüchen gekennzeichnet.

Die Erfindung wird im folgenden anhand von in den Figuren der Zeichnung dargestellten Ausführungsbeispielen näher erläutert. Es zeigt:

die bereits angesprochene Fig. 1 die erfindungsgemässe Ausbildung einer Verstärkerschaltung;

Fig. 2 ein Schaltbild einer Verstärkerschaltung mit mehr als einem Operationsverstärker; und

Fig. 3 ein Schaltbild einer Verstärkerschaltung mit im Detail dargestelltem Operationsverstärker.

Da der Strom $J_e$ in der Verstärkerschaltung nach Fig. 1, der von der Ausgangsstufe des Operationsverstärkers OV geführt wird, um Grössenordnungen alle übrigen in der Verstärkerschaltung fliessenden Ströme übertrifft, ist es ausreichend, wenn man den Einfluss dieses Stromes auf den Gegenkopplungsfusspunkt, d.h. auf den Gegenkopplungswiderstand R2 und auf den Widerstand R4, d.h. also mit anderen Worten auf die mit den besagten Widerständen verbundene Anschlussklemme B, eliminiert. Um dieses Ziel zu erreichen, könnte man an sich den Versorgungsstrom der den Endstrom $J_e$ führenden Ausgangsstufe des Operationsverstärkers OV über einen Extra-Draht an die gemeinsame Anschlussklemme B für das Bezugspotential $-V_s$ legen. Jedoch ist, wie die Erfahrung zeigt, diese Massnahme nicht ausreichend. Aus diesem Grund ist gemäss der Erfindung für die Verbindung des Endstromes $J_e$ des Operationsverstärkers OV zu dem das Versorgungspotential $-V_s$ liefernden Pol der Gleichstromversorgungsquelle eine lediglich zu diesem Zweck vorgesehene Anschlussklemme B' an dem die Verstärkerschaltung aufnehmenden Halbleiterchip angebracht, die lediglich zu der Endstufe des Operationsverstärkers OV führt, während zwischen der anderen durch das Bezugspotential $-V_s$ zu beaufschlagenden Versorgungsklemme B und der den Endstrom $J_e$ führenden Erdungsklemme B' keinerlei leitende keinerlei interne leitende Verbindung vorgesehen ist.

Bei der erfindungsgemässen Lösung benötigt man also zwei Anschlüsse des die Verstärkerschaltung aufnehmenden Halbleiterchips, nämlich die beiden Klemmen B und B', deren Aufgabe inbezug auf die interne Schaltung bereits definiert ist, und die intern voneinander völlig isoliert sind. Es empfiehlt sich weiter, dass diese beiden Klemmen B und B' erst unter Vermittlung des das Bezugspotential $-V_s$ liefernden Polanschlusses der Versorgungsquelle miteinander in leitende Verbindung gelangen, so dass auch die externen Verbindungen von den beiden Klemmen B und B' zur Versorgungsspannungsquelle voneinander getrennt verlaufen.

Es empfiehlt sich ausserdem, wenn der Anschluss B' mit der Kühllasche des IC's leitend verbunden und letztere zur Ableitung des Endstroms $J_e$ des Operationsverstärkers zur Versorgungsspannungsquelle vorgesehen ist.

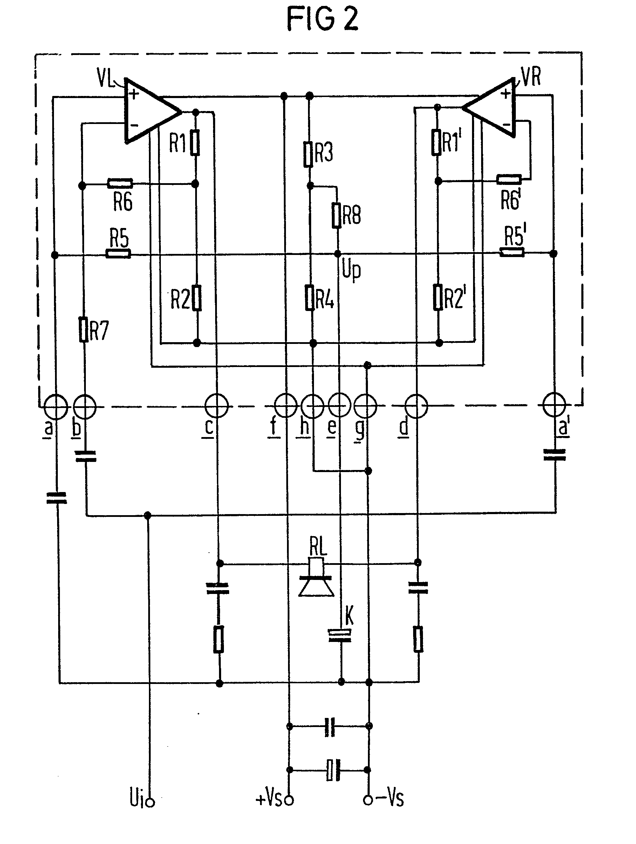

Die Figur 2 zeigt, wie bereits bemerkt, eine Ausgestaltung der erfindungsgemässen Verstärkerschaltung mit zwei übereinstimmenden Operationsverstärkern VL und VR, die durch eine entsprechende externe Beschaltung als Brückenverstärker zum Betreiben eines Lautsprechers als Last $R_L$ dient. Sie kann aber auch, wie aus der EP-A-0 106 088 (veröffentlicht am 25.4.1984) hervorgeht, als Stereoverstärker betrieben werden.

Die in Figur 2 dargestellte Ausgestaltung einer Halbleiter-Verstärkerschaltung gemäss der vorliegenden Erfindung zeigt, dass jeder der beiden Operationsverstärker VL und VR mit seinem nichtinvertierenden Signaleingang über je einen Versorgungswiderstand R5 bzw. R'5 an einen das Polarisationspotential Up führenden gemeinsa

men Knoten gelegt ist. Dieser das Potential Up führende Knoten liegt einerseits über einen Zwischenwiderstand R8 am Teilerpunkt eines Spannungsteilers R4, R3, dessen einer Endanschluss durch das Bezugspotential $-V_s$ und dessen anderer Endanschluss durch das Versorgungspotential $+V_s$ versorgt ist. Andererseits liegt der besagte Knoten mit dem Potential Up über einen Kondensator K am Bezugspotential $-V_s$. Dabei ist zu beachten, dass der Spannungsteiler R4, R3 und der besagte Schaltungsknoten im Inneren des IC's angeordnet ist und die Verbindung zum Siebungskondensator K über eine Anschlussklemme e erfolgt. Der zweite Anschluss des Kondensators K liegt an dem das Bezugspotential $-V_s$ liefernden Pol der Versorgungsspannungsquelle.

Der invertierende Eingang des Operationsverstärkers VL liegt über einen Widerstand R7 an einer Signaleingangsklemme b, die über einen (nicht näher bezeichneten) Kopplungskondensator an den Signaleingang für die zu verarbeitenden Signale Ui gelegt ist. In hierzu übereinstimmender Weise ist der nichtinvertierende Signaleingang des anderen Operationsverstärkers VR über die zugehörige Signaleingangsklemme a' des die Verstärkerschaltung aufnehmenden Halbleiterplättchens (ebenfalls unter Vermittlung eines (nicht bezeichneten) Kondensators) mit dem Eingang der Gesamtschaltung für das vom Verstärker zu verarbeitende Signal Ui verbunden. Als Unterschied zwischen den beiden Operationsverstärkern VL und VR ist lediglich festzustellen, dass im Falle des OP's VL der invertierte Signaleingang unter Vermittlung eines Widerstands R7 und im Falle des OP's VR der nichtinvertierende Signaleingang – und zwar ohne Vermittlung eines Vorwiderstands – an die zugehörige Signaleingangsklemme b bzw. a' angeschlossen ist. Zu bemerken ist in diesem Zusammenhang weiter, dass der Vorwiderstand R7 gleich dem zum Operationsverstärker VL gehörenden Gegenkopplungswiderstand R6 bemessen ist. Weiter ist festzustellen, dass bei einer anderen Betriebsweise der Verstärkerschaltung, z.B. im Falle der Verwendung als Stereoverstärker, auch der nichtinvertierende Signaleingang des Operationsverstärkers VL zur Beaufschlagung mit einem zu verarbeitenden Signal Ui vorgesehen sein kann. In diesem Falle wird das zu verarbeitende Signal Ui, z.B. ebenfalls über einen (nichtbezeichneten) Koppelkondensator an die zum nichtinvertierenden Signaleingang von VL führende Signaleingangsklemme a gelegt. In diesem Falle entfällt, wenigstens in den meisten Fällen, eine Signalbeaufschlagung der Signaleingangsklemme b und damit des invertierenden Signaleingangs des OP's VL.

Die ebenfalls zum integrierten Bereich der Schaltung gemäss Figur 2 gehörende Gegenkopplung R1, R2, R6 bzw. R1', R2' und R6' ist bei beiden Operationsverstärkern VL und VR in gleicher Weise ausgestaltet und bemessen. Ebenso wie beim OP VL der Signalausgang zunächst über den Widerstand R1 und dann über den Gegenkopplungswiderstand R6 mit seinem zugehörigen invertierenden Signaleingang verbunden ist, liegt im Falle der OP's VR der Signalausgang über den dem Widerstand R1 entsprechenden Widerstand R1' am Gegenkopplungswiderstand R6' und letzterer am invertierenden Signaleingang von VR. Ausserdem ist der dem dem Ausgang von VR abgewandte Anschluss des Widerstands R1' über den Widerstand R2' an die erste Klemme h für das Bezugspotential −$V_s$ gelegt. Dasselbe gilt für den am Ausgang des Operationsverstärkers VL liegenden Spannungsteilerwiderstand R1, der über den Widerstand R2 ebenfalls mit der Klemme h für das Bezugspotential angeschlossen ist. Schliesslich liegt noch der Fusspunkt R4 des bereits oben erwähnten und zur Spannungsversorgung des nichtinvertierten Signaleingangs der beiden Operationsverstärker VL und VR unter Vermittlung des Zwischenwiderstands R8 und je eines Versorgungswiderstands R5 bzw. R5' dienenden Spannungsteilers R3, R4 an der besagten Klemme h für das Bezugspotential −$V_s$.

Die genannte Klemme h ist ausserdem an diejenigen Teile der beiden Operationsverstärker VL und VR angeschlossen, die einerseits unmittelbar mit dem Bezugspotential −$V_s$ zu beaufschlagen sind, und die anderseits nicht den Endstrom $J_e$ des betreffenden Verstärkers sondern lediglich den Strom $J_v$ der zu dem betreffenden Verstärker VL bzw. VR gehörenden Vorstufe führen. Für die Versorgung der Endstufe der beiden Verstärker VL bzw. VR dient erfindungsgemäss eine zweite Versorgungsklemme g für das Bezugspotential −$V_s$, die beiden Operationsverstärkern VL und VR gemeinsam zugeordnet ist, und die erst ausserhalb der eigentlichen integrierten Schaltung eine leitende Verbindung zu der anderen Bezugsspannungsklemme h erhält.

Hinsichtlich der beiden Signalausgangsklemmen c und d ist festzustellen, dass sie durch den durch den Verstärker zu beaufschlagenden Lautsprecher RL überbrückt sind. Sie liegen ausserdem über je eine Serienschaltung aus einem Kondensator und einem Widerstand an dem das Bezugspotential −$V_s$ liefernden Pol der Versorgungsspannungsquelle.

Hinsichtlich des das Versorgungspotential +$V_s$ liefernden Pols dieser Versorgungsspannungsquelle ist festzustellen, dass sie an der Versorgungsklemme f liegt, die einerseits unmittelbar mit dem vom Bezugspotential −$V_s$ abgewandten Endanschluss des für die Spannungsversorgung des nicht invertierten Signaleingangs der beiden Operationsverstärker zuständigen Spannungsteiler R3, R4, also mit dem freien Anschluss des Widerstands R3, im Inneren des IC's verbunden ist. Anderseits liegt die besagte Klemme f für das Versorgungspotential +$V_s$ an allen Punkten der beiden Operationsverstärker VL und VR, die durch das Versorgungspotential +$V_s$ unmittelbar zu beaufschlagen sind, gleichgültig, ob sie zu den Vorstufen oder den Endstufen gehören.

Schliesslich ist noch im Einklang mit der schon genannten EP-A-0 106 088 (veröffentlicht am 25.4.1984) zu empfehlen, wenn der Gegenkopplungswiderstand R6 des Operationsverstärkers VL inbezug auf den zugehörigen Versorgungswiderstand R5 und dem von diesem zum Teilerpunkt des Spannungsteilers R3, R4 führenden Zwischenwiderstand R8 derart abgestimmt ist, dass R6=R5+2R8 und R6'=R5'+2R8 gilt. Für den Fall das beiden Operationsverstärker VL und VR inbezug auf den Aufbau und die Bemessung einander gleich sind, ist dann R6=R6'. Wie in der genannten Patentanmeldung dargelegt, wird aufgrund einer solchen Bemessung eine monolithische Zusammenfassung der beiden Operationsverstärker samt ihrer Gegenkopplung in einem gemeinsamen IC-Baustein erst möglich.

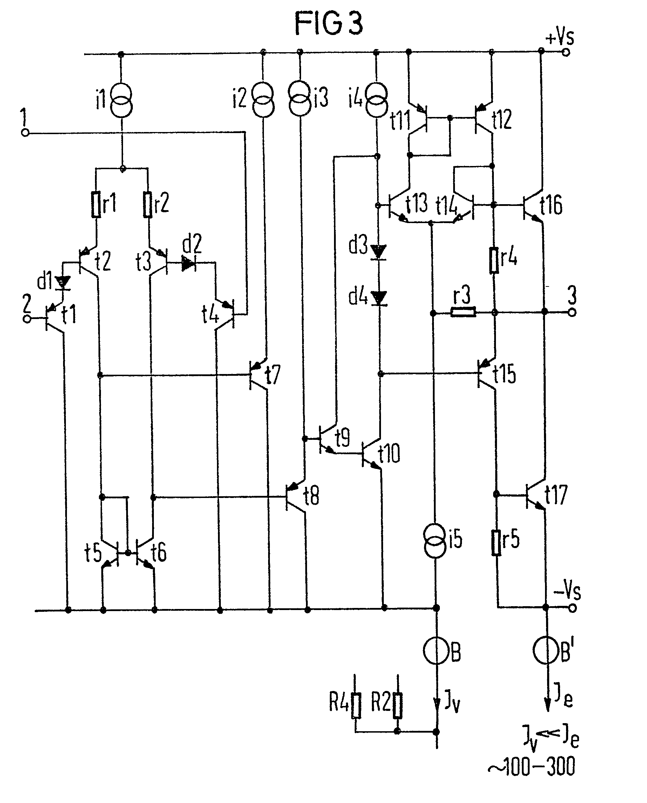

Die schaltungsgemässe Ausgestaltung der Operationsverstärker OV bzw. VL und VR richtet sich vorteilhaft nach dem aus Figur 3 ersichtlichen Schaltungsplan, der in komplementärer Bipolartechnik ausgeführt ist, und deren monolithische Realisierung keine Schwierigkeiten bereitet.

Der nichtinvertierende Eingang 1 eines solchen Verstärkers steuert die Basis eines pnp-Transistors t4, dessen Kollektor am Bezugspotential −$V_s$ und dessen Emitter an der Kathode d2 und über diese Diode d2 an der Basis eines zweiten pnp-Transistors t3 liegt. Der invertierende Eingang 2 entspricht in seiner Schaltung der des nichtinvertierenden Eingangs 1. Er bildet also den Basisanschluss eines dritten pnp-Transistors t1, dessen Kollektor ebenfalls am Bezugspotential −$V_s$ und dessen Emitter an der Kathode einer Diode d1 und über diese Diode d1 an der Basis eines vierten pnp-Transistors t2 liegt. Der zweite pnp-Transistor t3 ist über die Reihenschaltung zweier einander gleicher Widerstände r2, r1 über seinen Emitter mit dem Emitter des vierten pnp-Transistors t2 verbunden. Ausserdem liegt der Verbindungspunkt zwischen den beiden Widerständen r1 und r2 über eine Konstantstromquelle i1 an der Klemme C bzw. f für das Versorgungspotential +$V_s$, während das Bezugspotential −$V_s$ für den ersten pnp-Transistor t4 und den dritten pnp-Transistor t1 von der Klemme B bzw. h durch die aus Figur 1 bzw. 2 ersichtlichen IC-internen Verbindungen abgenommen und an die beiden Transistoren geliefert wird.

Der zweite pnp-Transistor t3 ist mit seinem Kollektor mit dem Kollektor eines ersten npn-Transistors t6 verbunden, dessen Emitter − ebenfalls über die besagte Klemme B bzw. h durch das Bezugspotential −$V_s$ versorgt ist und dessen Basis sowohl am Kollektor des vierten pnp-Transistors t2 als auch an der Basis und an dem Kollektor eines zweiten npn-Transistors t5 angeschlossen ist. Der Emitter dieses npn-Transistors t5 liegt wiederum an der zur Beaufschlagung der bisher genannten Transistoren mit dem Bezugspotential −$V_s$ zuständigen Versorgungsklemme B bzw. h.

Sowohl der Kollektor des zweiten pnp-Transistors t3 als auch der Kollektor des vierten pnp-Transistors t2 steuert die Basis jeweils eines weiteren pnp-Transistors t7 bzw. t8. Der Emitter des vom vierten pnp-Transistor t2 gesteuerten pnp-Transistors t7 liegt dabei über eine Stromquelle i2 an der Klemme A bzw. f für das Versorgungspotential +$V_s$ und mit seinem Kollektor an der Klemme B bzw. h für das Bezugspotential $-V_s$. Der Emitter des vom zweiten pnp-Transistor t gesteuerten pnp-Transistors t8 liegt über eine weitere Stromquelle i3 am Versorgungspotential $+V_s$ und mit seinem Kollektor ebenfalls an der bisher im Zusammenhang mit Figur 3 ausschliesslich genannten Klemme B bzw. h für das Versorgungspotential $-V_s$. Zum Unterschied gegenüber dem pnp-Transistors t7 liegt jedoch der Emitter des pnp-Transistors t8 an der Basis eines dritten npn-Transistors t9, während für den Transistor t7 eine analoge Anschaltung hierzu nicht vorgesehen ist.

Die Emitter-Kollektorstrecke des zuletzt eingeführten dritten npn-Transistors t9 ist von der Serienschaltung zweier gleichsinnig gepolter Dioden d3, d4 und der Basis-Kollektordiode eines vierten npn-Transistors t10 überbrückt. Hierzu liegt der Kollektor des dritten npn-Transistors t9 einerseits über eine vierte Konstantstromquelle i4 an der Klemme A bzw. f für das Versorgungspotential $+V_s$ und andererseits an der Anode der Diode d3. Die Kathode dieser Diode d3 liegt an der Anode der Diode d4, deren Kathode mit dem Kollektor des vierten npn-Transistors t10 verbunden ist. Die Basis des vierten npn-Transistors t10 liegt am Emitter des dritten npn-Transistors t9. Der Emitter des vierten npn-Transistors t10 ist über die Klemme B bzw. h an das Bezugspotential $-V_s$ gelegt, während sein Kollektor neben den bereits genannten Verbindungen noch eine unmittelbare Verbindung mit der Basis eines siebten pnp-Transistors t15 aufweist. Zu erwähnen ist schliesslich noch, dass der Kollektor des dritten npn-Transistors t9 noch an die Basis eines fünften npn-Transistors t13 gelegt ist.

Der zuletzt genannte npn-Transistor t13 bildet zusammen mit einem sechsten npn-Transistor t14 einen emittergekoppelten Differenzverstärker, dessen beide Emitter über eine fünfte Stromquelle i5 ebenfalls noch an die wiederholt in diesem Zusammenhang genannte und gleichzeitig für die Gegenkopplung R4, R2 usw. zuständige Klemme B bzw. h für das Bezugspotential $-V_s$ gelegt sind. Der Kollektor des fünften npn-Transistors t13 liegt an der Basis und am Kollektor eines achten pnp-Transistors t11, der mit seinem Emitter an der Klemme A bzw. f für das Versorgungspotential $+V_s$ angeschlossen ist und ausserdem mit seiner Basis und seinem Kollektor an der Basis eines neunten pnp-Transistors t12 liegt. Dieser pnp-Transistor t12 wird ebenfalls an seinem Emitter unmittelbar durch die Klemme A bzw. f für das Versorgungspotential $+V_s$ beaufschlagt und ist mit seinem Kollektor unmittelbar mit dem Kollektor und der Basis des sechsten npn-Transistors t14 verbunden.

Zwei weitere npn-Transistoren t16 und t17 gehören zur Ausgangsstufe des Operationsverstärkers und sind bezüglich ihrer Emitter-Kollektorstrecke in Reihe geschaltet. Dabei liegt der Kollektor des siebenten npn-Transistors t16 an der Klemme A bzw. f für das Versorgungspotential $+V_s$ und sein Emitter am Signalausgang 3 des betreffenden Operationsverstärkers. Andererseits ist der Emitter des achten npn-Transistors t17 entsprechend der Lehre der vorliegenden Erfindung nicht mit der bishergenannten Klemme B bzw. h sondern mit der eigens für die Endstufe des Operationsverstärkers vorgesehene Klemme B' bzw. g für das Bezugspotential $-V_s$ verbunden, so dass der Endstrom $J_e$ des betreffenden Operationsverstärkers nicht mit den Fusspunkten der Spannungsteiler R1, R2 und R3, R4 bzw. R1', R2' in Berührung kommen kann. Der Kollektor des achten npn-Transistors t17 ist unmittelbar mit dem Signalausgang 3 des Operationsverstärkers verbunden. Die Basis des achten npn-Transistors t17 ist mittels eines Widerstandes r5 mit dem Bezugspotential $-V_s$ – und zwar ebenfalls nur über die Klemme B' bzw. g – verbunden. Die Basis des npn-Transistors t17 liegt ausserdem am Kollektor des siebenten pnp-Transistors t15, der ebenfalls noch zur Endstufe gehört.

Die Basis des siebenten npn-Transistors t16 hingegen ist über einen Widerstand r4 sowohl mit dem Signalausgang 3 des Operationsverstärkers als auch mit dem Emitter des siebenten pnp-Transistors t15 verbunden. Ausserdem liegt die Basis des siebenten npn-Transistors t16 am Kollektor und an der Basis des sechsten npn-Transistors t14. Schliesslich ist noch zu erwähnen, dass der Signalausgang 3 des Operationsverstärkers über einen Widerstand r3 mit dem Emitter des fünften bzw. des sechsten npn-Transistors t13 bzw. t14 verbunden ist.

Die aus Figur 3 ersichtliche Anschaltung des mit seinem Kollektor an der Klemme B bzw. h für das Bezugspotential $-V_s$ liegenden pnp-Transistors t7 hat die Aufgabe, den Basisstrom des pnp-Transistors t8 zu kompensieren.

Die soeben beschriebene Ausgestaltung für den einzelnen Operationsverstärker bringt folgende wesentliche Vorteile:

a) mit den Dioden d1 und d2 wird der Gleichtaktbereich der Eingangsklemmen 1 und 2 des Operationsverstärkers bis auf $-V_s$ sichergestellt;

b) die Offsetminimalisierung erreicht man durch folgende Massnahmen:

1) die Basisströme der Transistoren t5 und t6 kompensiert man für die typische Stromverstärkung über das Emitter-Flächenverhältnis von t5 und t6;

2) der Basisstrom von t8 wird, wie bereits angedeutet, durch den Basisstrom eines gleichen pnp-Transistors t7 kompensiert, der den gleichen Kollektorstrom wie t8 führt. Es muss also i2 = i3 gelten.

## Patentansprüche

1. Integrierte Verstärkerschaltung mit einem zwei interne Bezugspotentialanschlüsse aufweisenden Operationsverstärker (OV), mit einer am nichtinvertierenden Eingang (+) des Operationsverstärkers (OV) liegenden und vorzugsweise über einen externen Kondensator ($C_K$) zu beaufschlagenden Signaleingangsklemme (C), mit einer mit dem Signalausgang des Operationsverstärkers verbundenen Signalausgangsklemme (D), mit einer durch ein Versorgungspotential

(+$V_s$) zu beaufschlagenden ersten Versorgungsklemme (A) sowie mit einer durch das Bezugspotential (−$V_s$) zu beaufschlagenden zweiten Versorgungsklemme (B), wobei die Versorgungsklemmen (A, B) mit den durch das Versorgungspotential (+$V_s$) bzw. das Bezugspotential (−$V_s$) zu beaufschlagenden internen Anschlüssen des Operationsverstärkers (OV) verbunden sind, bei der ferner der Signalausgang des Operationsverstärkers (OV) über einen ersten ohmschen Spannungsteiler (R1, R2) an das Bezugspotential (−$V_s$) gelegt und der Teilerpunkt dieses Spannungsteilers (R1, R2) zwecks Erzielung einer reellen Gegenkopplung an den invertierenden Signaleingang des Operationsverstärkers (OV) mittels eines ohmschen Widerstandes (R6) gelegt ist, bei der der nichtinvertierende Eingang (+) des Operationsverstärkers (OV) über einen Versorgungswiderstand (R5) mit dem Teilerpunkt eines zweiten ohmschen Spannungsteilers (R3, R4) verbunden ist, dessen einer Endanschluss an der das Versorgungspotential (+$V_s$) führenden Versorgungsklemme (A) liegt, während der andere Endanschluss dieses zweiten Spannungsteilers (R3, R4) durch das Bezugspotential (−$V_s$) beaufschlagt ist, dadurch gekennzeichnet, dass die zweite Versorgungsklemme (B; <u>h</u>) lediglich zur Versorgung der Eingangsstufe des Operationsverstärkers (OV) über einen der beiden internen Bezugspotentialanschlüsse sowie des ersten und des zweiten ohmschen Spannungsteilers (R1, R2; R3, R4) mit Bezugspotential dient und dass eine dritte, durch das Bezugspotential (−$V_s$) zu beaufschlagende, lediglich der Bezugspotentialversorgung der Ausgangsstufe des Operationsverstärkers (OV) über den anderen der beiden internen Bezugspotentialanschlüsse dienende Versorgungsklemme (B'; <u>g</u>) ohne interne leitende Verbindung zur zweiten Versorgungsklemme (B; <u>h</u>) vorgesehen ist.

2. Anordnung nach Anspruch 1, dadurch gekennzeichnet, dass die Beaufschlagung der beiden Anschlussklemmen für das Bezugspotential (−$V_s$) durch je eine eigene Zuleitung von der das Bezugspotential (−$V_s$) liefernden Versorgungsspannungsquelle erfolgt.

3. Anordnung nach Anspruch 1 oder 2, dadurch gekennzeichnet, dass die Zuleitung von der Versorgungsspannungsquelle zu der für die Versorgung der Endstufe des Operationsverstärkers (OV) zuständigen Versorgungsklemme (B') für das Bezugspotential (−$V_s$) zugleich als Kühllasche für die integrierte Verstärkerschaltung dient.

**Revendications**

1. Circuit amplificateur intégré, comprenant un amplificateur opérationnel (OV), présentant deux connexions internes de potentiel de référence, une borne d'entrée du signal (C), reliée à l'entrée non inverseuse (+) de l'amplificateur opérationnel (OV) et à laquelle le signal est appliqué de préférence via un condensateur externe ($C_K$), une borne de sortie du signal (D), reliée à la sortie du signal de l'amplificateur opérationnel, une première borne d'alimentation (A), à laquelle est à appliquer un potentiel d'alimentation (+$V_s$), et une seconde borne d'alimentation (B), à laquelle est à appliquer le potentiel de référence (−$V_s$), les bornes d'alimentation (A, B), étant reliées aux connexions internes, à soumettre au potentiel d'alimentation (+$V_s$), respectivement au potentiel de référence (−$V_s$), dans lequel, en outre, la sortie du signal de l'amplificateur opérationnel (OV) est reliée à travers un premier diviseur de tension ohmique (R1, R2) au potentiel de référence (−$V_s$) et le point de division de ce diviseur de tension (R1, R2), en vue de l'obtention d'une contre-réaction réelle, est relié par une résistance ohmique (R6) à l'entrée de signal inverseuse de l'amplificateur opérationnel (OV), dans lequel l'entrée non inverseuse (+) de l'amplificateur opérationnel (OV) est reliée à travers une résistance d'alimentation (R5) au point de division d'un second diviseur de tension ohmique (R3, R4) dont une connexion terminale est reliée à la borne d'alimentation (A) présentant le potentiel d'alimentation (+$V_s$), tandis que l'autre connexion terminale de ce second diviseur de tension (R3, R4) est soumise au potentiel de référence (−$V_s$), caractérisé en ce que la seconde borne d'alimentation (B; <u>h</u>) sert uniquement à l'alimentation, en potentiel de référence, de l'étage d'entrée de l'amplificateur opérationnel (OV), à travers l'une des deux connexions internes de potentiel de référence, ainsi que du premier et du second diviseur de tension ohmique (R1, R2; R3, R4), et qu'une troisième borne d'alimentation (B'; <u>g</u>) est prévue, à laquelle de potentiel de référence (−$V_s$) est à appliquer et qui sert uniquement à l'alimentation en potentiel de référence de l'étage de sortie de l'amplificateur opérationnel (OV), à travers l'autre des deux connexions de potentiel de référence internes, sans liaison conductive interne avec la seconde borne d'alimentation (B; <u>h</u>).

2. Dispositif selon la revendication 1, caractérisé en ce que l'alimentation des deux bornes de raccordement pour le potentiel de référence (−$V_s$), depuis la source de tension d'alimentation fournissant ce potentiel, s'effectue par une ligne séparée pour chaque borne.

3. Dispositif selon la revendication 1 ou 2, caractérisé en ce que la ligne d'alimentation allant de la source de tension d'alimentation à la borne d'alimentation (B'), chargée de l'alimentation de l'étage de sortie de l'amplificateur opérationnel (OV) en potentiel de référence (−$V_s$), sert en même temps d'attache de refroidissement pour le circuit amplificateur intégré.

**Claims**

1. An integrated amplifier circuit comprising an operational amplifier (OV) which has two internal reference potential junction points, comprising a signal input terminal (C) connected to the noninverting input (+) of the operational amplifier (OV) and preferably fed via an external capacitor ($C_K$), comprising a signal output terminal (D) connected to the signal output of the operational amplifier, comprising a first supply terminal (A) to be supplied with a supply potential (+$V_s$), and

comprising a second supply terminal (B) to be supplied with the reference potential (−Vₛ), where the supply terminals (A,B) to be supplied with the supply potential (+Vₛ) and the reference potential (−Vₛ) respectively are connected to the internal junction points of the operational amplifier (OV), where moreover the signal output of the operational amplifier (OV) is connected via a first ohmic voltage divider (R1, R2) to the reference potential (−Vₛ) and the divider point of this voltage divider (R1, R2) is connected to the inverting signal input of the operational amplifier (OV) by means of a resistor (R6) in order to produce a real negative feedback, where the noninverting input (+) of the operational amplifier (OV) is connected via a supply resistor (R5) to the divider point of a second ohmic voltage divider (R3, R4) whose first end terminal is connected to the supply terminal (A) which conducts the supply potential (+Vₛ) whereas the other end terminal of this second voltage divider (R3, R4) is acted upon by the reference potential (−Vₛ), characterised in that the second supply terminal (B; h̲) serves merely to supply reference potential to the input stage of the operational amplifier (OV) via one of the two internal reference potential junction points and to the first and second ohmic voltage divider (R1, R2; R3, R4) and that a third supply terminal (B'; g̲) is provided which has no internal conductive connection to the second supply terminal (B; h̲) and serves merely to supply reference potential to the output stage of the operational amplifier (OV) via the other of the two internal reference potential junction points.

2. An arrangement as claimed in Claim 1, characterised in that the two connection terminals for the reference potential (−Vₛ) are each supplied, via a separate supply line, from the supply voltage source which supplies the reference potential (−Vₛ).

3. An arrangement as claimed in Claim 1 or 2, characterised in that the supply line from the supply voltage source to the supply terminal (B') for the reference potential (−Vₛ), which is responsible for supplying the end stage of the operational amplifier (OV), simultaneously serves as a heat sink for the integrated amplifier circuit.

1/3

FIG 1

2/3

FIG 2

FIG 3